# EUROPEAN PATENT APPLICATION

(11) **EP 4 796 934 A1**
(43) Date of publication of application: **26.08.2026**
(21) Application number: 26160804.6
(22) Date of filing: 25.02.2026
(51) Int. Cl.: G01R 15/00

(54) **MULTI-GAIN SIMULTANEOUS SIGNAL SAMPLING**

(30) Priority: 25.02.2025 US 202563762823 P; 23.01.2026 US 202619457863
(71) Applicant: Vertiv Corporation, Westerville, OH 43082 (US)
(72) Inventor: PELTIER, Jason D., Westerville, 43082 (US); CAMEY, Kevin B., Westerville, 43082 (US); ESCHHOFEN, Kevin K., Westerville, 43082 (US); KRAJEWSKI, Gary L., Westerville, 43082 (US)
(74) Representative: Bryn-Jacobsen, Caelia

(57) **Abstract**

A signal monitoring system may include two or more amplifiers to simultaneously amplify an input analog signal and generate two or more amplified analog signals, where each of the two or more amplifiers is configured to amplify the input analog signal with a different fixed gain value. The system may further include two or more analog to digital converters to simultaneously digitize the two or more amplified analog signals with a common sampling rate and generate two or more digitized signals. The system may further include a controller to generate a full resolution signal from the two or more digitized signals by selecting on a sample-by-sample basis each value of the full resolution signal from a particular one of the two or more digitized signals associated with an undistorted representation of the input analog signal.

## Description

### CROSS-REFERENCE TO RELATED APPLICATIONS

The present application claims the benefit of and priority to U.S. Provisional Patent Application No. 63/762,823, filed February 25, 2025, naming Jason D. Peltier, Kevin B. Carney, Kevin K. Eschhofen, and Gary L. Krajewski as inventors, and U.S. Non-Provisional Patent Application No. 19/457,863, filed January 23, 2026.

### TECHNICAL FIELD

The present disclosure relates generally to alternating current (AC) power monitoring, more particularly, to simultaneous sampling of AC waveforms with multiple gains.

### BACKGROUND

Power monitoring is commonly used in power distribution networks to measure properties of power signals such as, but not limited to, voltage, current, power, and energy. Advanced applications such as, but not limited to, artificial intelligence (AI) applications may be characterized by rapid changes of current or other properties of such power signals. However, rapid changes of power signal properties such as, but not limited to, current presents challenges for power monitoring circuitry. For example, fixed-gain power monitoring circuitry may either clamp when high gain values or used or may provide relatively low accuracy when low gain values are used. As another example, power monitoring circuits utilizing variable gain may provide suffer from temporary signal degradation as gain is adjusted. There is therefore a need to develop systems and methods to address the above deficiencies.

### SUMMARY

In some examples, a signal monitoring system may include two or more amplifiers to simultaneously amplify an input analog signal and generate two or more amplified analog signals. Each of the two or more amplifiers may be configured to amplify the input analog signal with a different fixed gain value. The system may include two or more analog to digital converters (ADCs) to simultaneously digitize the two or more amplified analog signals with a common sampling rate and generate two or more digitized signals. The system may include a controller including one or more processors configured to generate a full resolution signal from the two or more digitized signals by selecting on a sample-by-sample basis each value of the full resolution signal from a particular one of the two or more digitized signals associated with an undistorted representation of the input analog signal.

In some examples, selecting on the sample-by-sample basis each value of the full resolution signal from the particular one of the two or more digitized signals associated with the undistorted representation of the input analog signal may include identifying when any of the two or more digitized signals are distorted. Selecting on the sample-by-sample basis each value of the full resolution signal from the particular one of the two or more digitized signals associated with the undistorted representation of the input analog signal may further include selecting on the sample-by-sample basis each value of the full resolution signal from the particular one of the two or more digitized signals associated with a highest gain while providing the undistorted representation of the input analog signal.

In some examples, the one or more processors of the controller may be further configured to generate one or more measurements associated with the input analog signal based on the full resolution signal.

In some examples, the one or more measurements may include at least one of a root-mean-square (RMS) measurement, a current measurement, a voltage measurement, a power measurement, or an energy measurement.

In some examples, the one or more processors of the controller may be further configured to generate a constant-gain signal from at least one of the full resolution signal or the two or more digitized signals based on the fixed gain value associated with the particular one of the two or more digitized signals.

In some examples, the one or more processors of the controller may be further configured to provide the constant-gain signal for display as a waveform representation of the input analog signal.

In some examples, the one or more processors of the controller may be configured to switch between different ones of the two or more digitized signals when generating the full resolution signal while maintaining signal continuity.

In some examples, the two or more amplifiers may include two amplifiers.

In some examples, the input analog signal may have a dynamic range exceeding an undistorted operating range of any single one of the two or more amplifiers.

In some examples, a signal monitoring system may include a controller including one or more processors configured to receive two or more digitized signals from two or more ADCs configured to simultaneously digitize two or more amplified analog signals from two or more amplifiers with a common sampling rate. The two or more amplifiers may be configured to simultaneously amplify an input analog signal with different fixed gain values. The one or more processors may be configured to generate a full resolution signal from the two or more digitized signals by selecting on a sample-by-sample basis each value of the full resolution signal from a particular one of the two or more digitized signals associated with an undistorted representation of the input analog signal.

In some examples, selecting on the sample-by-sample basis each value of the full resolution signal from the particular one of the two or more digitized signals associated with the undistorted representation of the input analog signal may include identifying when any of the two or more digitized signals are distorted. Selecting on the sample-by-sample basis each value of the full resolution signal from the particular one of the two or more digitized signals associated with the undistorted representation of the input analog signal may further include selecting on the sample-by-sample basis each value of the full resolution signal from the particular one of the two or more digitized signals associated with a highest gain while providing the undistorted representation of the input analog signal.

In some examples, the one or more processors of the controller may be further configured to generate one or more measurements associated with the input analog signal based on the full resolution signal.

In some examples, the one or more processors of the controller may be further configured to generate a constant-gain signal from at least one of the full resolution signal or the two or more digitized signals based on the fixed gain value associated with the particular one of the two or more digitized signals.

In some examples, the one or more processors of the controller may be further configured to provide the constant-gain signal for display as a waveform representation of the input analog signal.

In some examples, a signal monitoring method may include amplifying an input analog signal simultaneously with two or more amplifiers to generate two or more amplified analog signals. Each of the two or more amplifiers may be configured to amplify the input analog signal with a different fixed gain value. The method may include digitizing the two or more amplified analog signals simultaneously with two or more ADCs having a common sampling rate to generate two or more digitized signals. The method may include generating a full resolution signal from the two or more digitized signals by selecting on a sample-by-sample basis each value of the full resolution signal from a particular one of the two or more digitized signals associated with an undistorted representation of the input analog signal.

In some examples, selecting on the sample-by-sample basis each value of the full resolution signal from the particular one of the two or more digitized signals associated with the undistorted representation of the input analog signal may include identifying when any of the two or more digitized signals are distorted. Selecting on the sample-by-sample basis each value of the full resolution signal from the particular one of the two or more digitized signals associated with the undistorted representation of the input analog signal may further include selecting on the sample-by-sample basis each value of the full resolution signal from the particular one of the two or more digitized signals associated with a highest gain while providing the undistorted representation of the input analog signal.

In some examples, the method may further include generating one or more measurements associated with the input analog signal based on the full resolution signal.

In some examples, the one or more measurements may include at least one of an RMS measurement, a current measurement, a voltage measurement, a power measurement, or an energy measurement.

In some examples, the method may further include generating a constant-gain signal from at least one of the full resolution signal or the two or more digitized signals based on the fixed gain value associated with the particular one of the two or more digitized signals.

In some examples, the method may further include providing the constant-gain signal for display as a waveform representation of the input analog signal.

It is to be understood that both the foregoing general description and the following detailed description are exemplary and explanatory only and are not necessarily restrictive. The accompanying drawings, which are incorporated in and constitute a part of the specification, illustrate examples and together with the general description, serve to explain the principles of the present disclosure.

### BRIEF DESCRIPTION OF DRAWINGS

The numerous advantages of the disclosure may be better understood by those skilled in the art by reference to the accompanying figures.
FIG. 1 illustrates a block diagram view of a monitoring system, in accordance with one or more examples of the present disclosure.
FIG. 2 illustrates monitoring of an input analog signal diagrammatically, in accordance with one or more examples of the present disclosure.
FIG. 3 is a flow diagram illustrating steps performed in a signal monitoring method, in accordance with one or more examples of the present disclosure.

### DETAILED DESCRIPTION

Reference will now be made in detail to the subject matter disclosed, which is illustrated in the accompanying drawings. The present disclosure has been particularly shown and described with respect to certain examples and specific features thereof. The examples set forth herein are taken to be illustrative rather than limiting. It should be readily apparent to those of ordinary skill in the art that various changes and modifications in form and detail may be made without departing from the scope of the disclosure.

Examples of the present disclosure are directed to systems and methods providing high-quality full-resolution sampling of an input analog signal by simultaneously amplifying and digitizing the input analog signal with multiple amplifiers having different fixed gain values and associated multiple analog to digital (ADC) converters to create multiple digitized signals, followed by generating a full resolution signal by selecting each value of the full resolution signal on a sample-by-sample basis from one of the digitized signals.

Such a system may facilitate accurate monitoring of the input analog signal without signal loss, even if an amplitude of the input analog signal rapidly changes. For example, each value of the full resolution signal may be selected from one of the digitized signals associated with an amplifier providing a highest gain without distorting the input analog signal. Put another way, systems and methods disclosed herein may provide a high dynamic range for signal sampling and monitoring without loss or distortion.

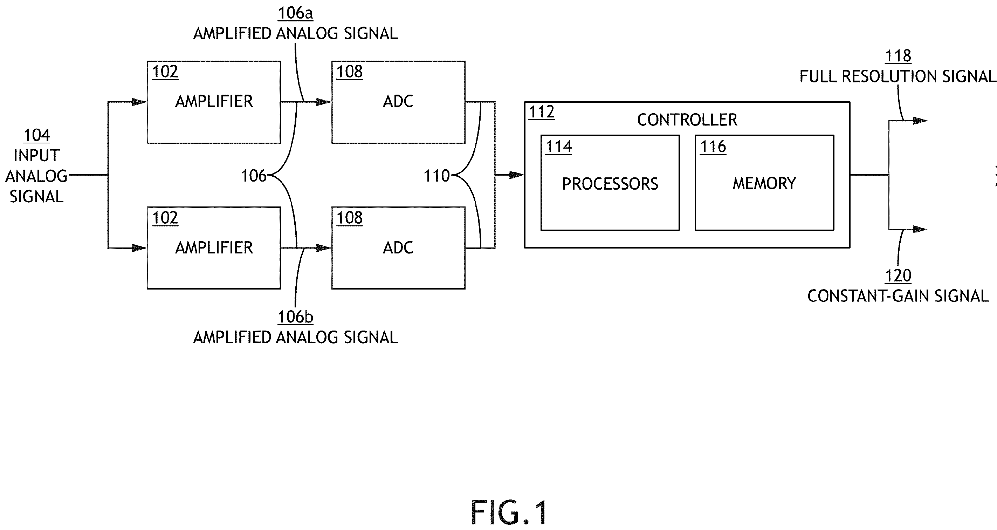

Referring now to FIGS. 1-3, systems and methods providing signal monitoring are described in greater detail, in accordance with one or more examples of the present disclosure.

FIG. 1 illustrates a block diagram view of a monitoring system 100, in accordance with one or more examples of the present disclosure.

In some examples, the monitoring system 100 includes two or more amplifiers 102 arranged to simultaneously amplify an input analog signal 104 with different fixed gain values. As shown in FIG. 1, each amplifier 102 may generate a different amplified analog signal 106. In this way, the monitoring system 100 may generate two or more amplified analog signals 106, each associated with a different one of the two or more amplifiers 102.

The monitoring system 100 may include any number of amplifiers 102. In some examples, the monitoring system 100 includes two amplifiers 102 to provide simultaneous dual gain amplification (e.g., simultaneous low-gain and high-gain amplification). In some examples, the monitoring system 100 includes three or more amplifiers 102. It is contemplated herein that the number of amplifiers 102 may be selected based on factors such as, but not limited to, space, complexity, and cost. For example, increasing a number of amplifiers 102 may improve a dynamic range of the monitoring system 100 as a whole, but may also increase both system complexity and cost.

Each amplifier 102 may be formed from any component or components known in the art suitable for amplifying an input analog signal such as, but not limited to, transistors and operational amplifiers (e.g., op amps). In some examples, an amplifier 102 is a non-switching amplifier (e.g., a linear amplifier) in which components are driven with fixed or constant inputs. In some examples, an amplifier 102 is a switching amplifier in which one or more components (e.g., one or more internal transistors) are driven by control signals in alternating modes to promote amplification.

In some examples, the monitoring system 100 includes two or more analog to digital (ADC) converters 108 configured to digitize the two or more amplified analog signals 106 to generate two or more digitized signals 110. The ADC converters 108 may have the same or different operational ranges or resolutions. In some examples, an operational range and/or resolution of each ADC converter 108 is tailored based on the gain of the associated amplifier 102. In some examples, the ADC converters have common operational ranges or resolutions.

In some examples, the monitoring system 100 includes a controller 112 including one or more processors 114 configured to execute program instructions, which may be stored on a memory 116. For the purposes of the present disclosure, the term "processor" or "processing element" may be broadly defined to encompass any device having one or more processing or logic elements such as, but not limited to, one or more digital signal processors (DSPs), one or more field-programmable gate arrays (FPGAs), one or more application specific integrated circuit (ASIC) devices, or one or more microprocessor devices. In this sense, the one or more processors 114 may include any device configured to execute algorithms and/or instructions. The memory 116 may include any storage medium known in the art suitable for storing program instructions executable by the associated one or more processors 114. For example, the memory 116 may include a non-transitory memory medium. By way of another example, the memory 116 may include, but is not limited to, a read-only memory (ROM), a random-access memory (RAM), a magnetic or optical memory device (e.g., disk), a magnetic tape, a solid-state drive, or the like. It is further noted that the memory 116 may be, but is not required to be, housed in a common controller housing with the one or more processors 114.

In some examples, the controller 112 (e.g., via the processors 114) generates a full resolution signal 118 from the two or more digitized signals 110 on a sample-by-sample basis. For example, the controller 112 may select each value of the full resolution signal 118 from one of the two or more digitized signals 110. This selection may be based on any suitable criteria.

As an illustration, it may be desirable to maximize a gain (e.g., when amplifying the input analog signal 104) while avoiding distortion such as, but not limited to, clamping. Accordingly, the controller may generate the full resolution signal 118 from the digitized signal 110 associated with an amplifier 102 having the highest gain that does not result in distortion. This process may be performed dynamically, whereby the controller 112 may dynamically use different digitized signals 110 at different times depending on the amplitude of the input analog signal 104. Further, since the monitoring system 100 generates multiple digitized signals 110 simultaneously associated with different gains, the controller 112 may rapidly switch between different digitized signals 110 when forming the full resolution signal 118 without any signal loss or distortion. In this way, the controller 112 may maintain signal continuity when switching between different digitized signals 110.

In some examples, the controller 112 generates a constant-gain signal 120 either from the full resolution signal 118 or directly from the two or more digitized signals 110. For example, each value of the constant-gain signal 120 may be normalized based on the gain of the amplifier 102 associated with the particular digitized signal 110 selected for that value. In this way, the constant-gain signal 120 may be an accurate representation of the input analog signal 104. The constant-gain signal 120 may be suitable for, but is not limited to, display (e.g., on a display device).

In some examples, the controller 112 generates one or more measurements associated with the input analog signal 104 based on the full resolution signal 118 and/or the constant-gain signal 120, either alone or in combination. The controller 112 may generate any type of measurements including, but not limited to, a root-mean-square (RMS) measurement. Further, this measurement may be associated with a current value, a voltage value, a power value, an energy value, or any other property of the input analog signal 104.

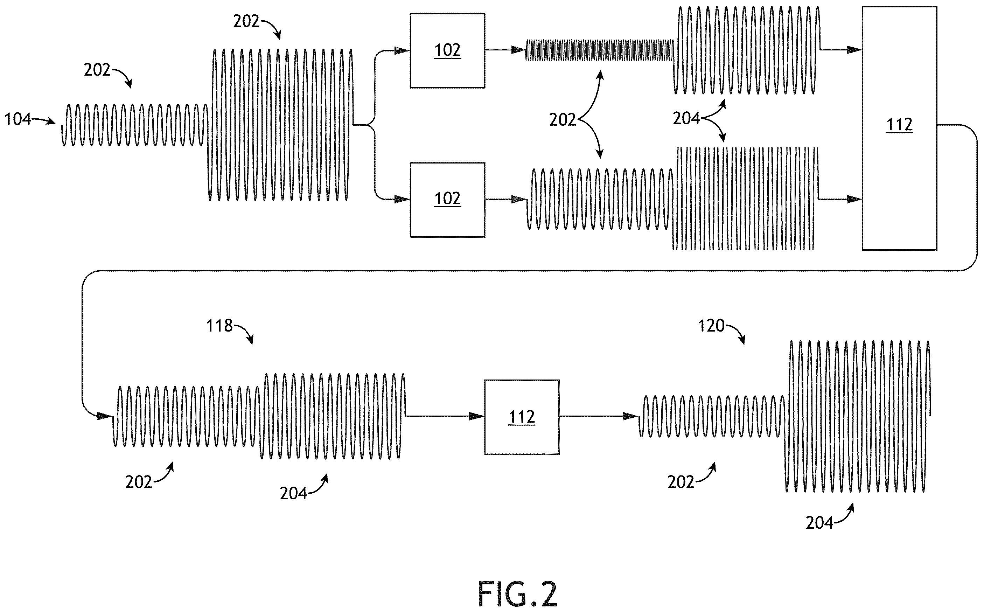

FIG. 2 illustrates monitoring of an input analog signal 104 diagrammatically, in accordance with one or more examples of the present disclosure. In FIG. 2, the input analog signal 104 has a first amplitude for a first timeframe 202, followed by a rapid transition to a second amplitude for a second timeframe. Such a signal may be difficult to monitor using existing techniques incorporating either a single fixed-gain amplifier or a variable amplifier. For example, the input analog signal 104 may be an alternating current signal having a dynamic range exceeding an undistorted operating range of any single fixed-gain amplifier. However, it is to be understood that the input analog signal 104 in FIG. 2 is merely illustrative and should not be interpreted as limiting the scope of the present disclosure. Rather, the input analog signal 104 may be any signal with any amplitude profile.

In FIG. 2, the input analog signal 104 is simultaneously amplified by two amplifiers 102 to produce two amplified analog signals 106 (labeled as 106a and 106b). In particular, FIG. 2 depicts a dual-amplifier configuration including a low-gain amplifier 102a and a high-gain amplifier 102b. FIG. 2 further illustrates that any given amplifier 102 with a fixed gain value may result in distortions and/or low signal quality for portions of an input analog signal 104 with a high dynamic range. For example, a first amplified analog signal 106a may have poor signal quality for a relatively low-amplitude portion in the first timeframe 202 but may have a high signal quality for a relatively high-amplitude portion in the second timeframe 204, whereas the second amplified analog signal 106b may have a high signal quality in the first timeframe 202 and a distorted (e.g., clamped or cut-off) signal in the second timeframe 204.

However, as described above, the monitoring system 100 (e.g., via the controller 112) may generate a full resolution signal 118 and/or a constant-gain signal 120 using sample-by-sample selection of data from the two digitized signals 110. In particular, FIG. 2 depicts a full resolution signal 118 formed from the second amplified analog signal 106b during the first timeframe 202 and formed from the first amplified analog signal 106a during the second timeframe 204. FIG. 2 also depicts a constant-gain signal 120 generated by controlling (e.g., normalizing) the gain of the full resolution signal 118 based on the gain of the amplifier 102 associated with the particular digitized signal 110 for each sample point, however this is merely an illustration and not a limitation. The constant-gain signal 120 may be directly generated from the two or more digitized signals 110 in some examples. As a result, the constant-gain signal 120 may provide an accurate representation of the time-varying amplitude of the input analog signal 104.

It is again noted that the sample-by-sample formation of the full resolution signal 118 and/or the constant-gain signal 120 from multiple fixed-gain amplifiers 102 may enable robust sampling and monitoring of the input analog signal 104 over a wide dynamic range (e.g., rapid amplitude variations) without suffering from distortion or temporary dropouts during time of rapid change.

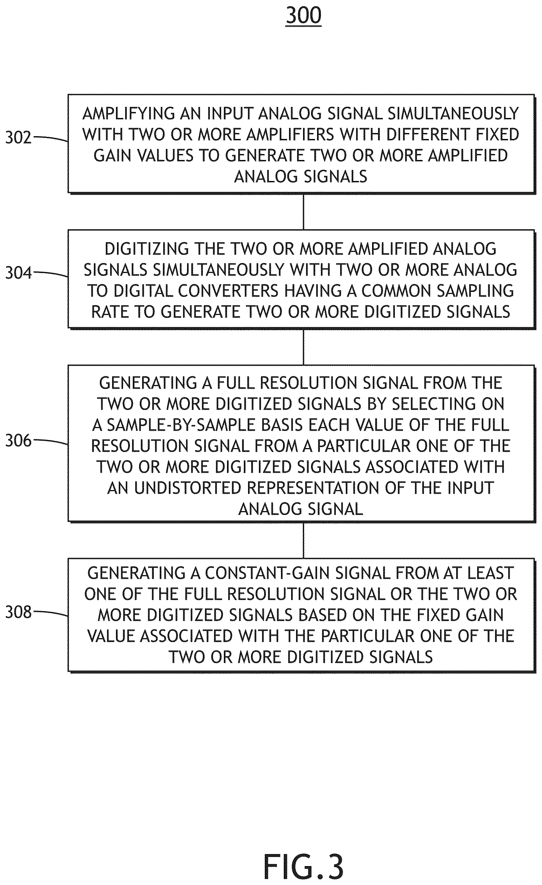

FIG. 3 is a flow diagram illustrating steps performed in a signal monitoring method 300, in accordance with one or more examples of the present disclosure. The examples and enabling technologies described previously herein in the context of the monitoring system 100 should be interpreted to extend to the method 300. It is further noted, however, that the method 300 is not limited to the architecture of the monitoring system 100.

The method 300 may include a step 302 of amplifying an input analog signal 104 simultaneously with two or more amplifiers 102 to generate two or more amplified analog signals 106, where each of the two or more amplifiers is configured to amplify the input analog signal 104 with a different fixed gain value. For example, the step 302 may be implemented in a dual-amplifying configuration, where a first amplifier 102 has a relatively low gain and the second amplifier 102 has a relatively high gain. As another example, the step 302 may be implemented with three or more amplifiers 102 with different fixed gain values.

The method 300 may include a step 304 of digitizing the two or more amplified analog signals 106 simultaneously with two or more analog to digital converters 108 having a common sampling rate to generate two or more digitized signals 110. In this way, each of the two or more digitized signals 110 may have the same number of samples with the same temporal spacing (e.g., temporal resolution).

The method 300 may include a step 306 of generating a full resolution signal 118 from the two or more digitized signals 110 by selecting on a sample-by-sample basis each value of the full resolution signal 118 from a particular one of the two or more digitized signals 110 associated with an undistorted representation of the input analog signal 104. For example, the step 306 may include selecting values of a digitized signal 110 associated with a highest gain (or at least an acceptably high gain) that does not result in distortion or poor signal quality at a given point in time (or time window). Since multiple digitized signals 110 associated with different gains are simultaneously generated in step 304, switching between different digitized signals 110 when forming the full resolution signal 118 in step 306 may be achieved without a time penalty and without signal loss.

The method 300 may include a step 308 of generating a constant-gain signal 120 from at least one of the full resolution signal 118 or the two or more digitized signals 110 based on the fixed gain value associated with the particular one of the two or more digitized signals 110. In this way, the constant-gain signal 120 may provide an accurate representation of the time-varying amplitude of the input analog signal 104.

Although not explicitly shown, the method 300 may further include a step of generating one or more measurements associated with the input analog signal 104 based on any combination of the full resolution signal 118 or the constant-gain signal 120. For example, the measurements may include, but are not limited to, RMS measurements. Further, the measurements may be associated with any property of the input analog signal 104 including, but not limited to, current, voltage, power, or energy.

The herein described subject matter sometimes illustrates different components contained within, or connected with, other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "connected" or "coupled" to each other to achieve the desired functionality, and any two components capable of being so associated can also be viewed as being "couplable" to each other to achieve the desired functionality. Specific examples of couplable include but are not limited to physically interactable and/or physically interacting components and/or wirelessly interactable and/or wirelessly interacting components and/or logically interactable and/or logically interacting components.

Further examples are set out in the clauses below:
1. A signal monitoring system comprising:
   two or more amplifiers to simultaneously amplify an input analog signal and generate two or more amplified analog signals, wherein each of the two or more amplifiers is configured to amplify the input analog signal with a different fixed gain value;
   two or more analog to digital converters to simultaneously digitize the two or more amplified analog signals with a common sampling rate and generate two or more digitized signals; and
   a controller including one or more processors configured to generate a full resolution signal from the two or more digitized signals by selecting on a sample-by-sample basis each value of the full resolution signal from a particular one of the two or more digitized signals associated with an undistorted representation of the input analog signal.
2. The signal monitoring system of clause 1, wherein selecting on the sample-by-sample basis each value of the full resolution signal from the particular one of the two or more digitized signals associated with the undistorted representation of the input analog signal comprises:
   identifying when any of the two or more digitized signals are distorted; and
   selecting on the sample-by-sample basis each value of the full resolution signal from the particular one of the two or more digitized signals associated with a highest gain while providing the undistorted representation of the input analog signal.
3. The signal monitoring system of clause 1 or clause 2, wherein the one or more processors of the controller are further configured to generate one or more measurements associated with the input analog signal based on the full resolution signal.
4. The signal monitoring system of clause 3, wherein the one or more measurements comprise:
   at least one of a root-mean-square (RMS) measurement, a current measurement, a voltage measurement, a power measurement, or an energy measurement.
5. The signal monitoring system of any one of clauses 1 to 4, wherein the one or more processors of the controller are further configured to generate a constant-gain signal from at least one of the full resolution signal or the two or more digitized signals based on the fixed gain value associated with the particular one of the two or more digitized signals.
6. The signal monitoring system of clause 5, wherein the one or more processors of the controller are further configured to provide the constant-gain signal for display as a waveform representation of the input analog signal.
7. The signal monitoring system of any one of clauses 1 to 6, wherein the one or more processors of the controller are configured to switch between different ones of the two or more digitized signals when generating the full resolution signal while maintaining signal continuity.
8. The signal monitoring system of any one of clauses 1 to 7, wherein the two or more amplifiers comprise:
   two amplifiers; or
   three or more amplifiers.
9. The signal monitoring system of any one of clauses 1 to 8, wherein the input analog signal has a dynamic range exceeding an undistorted operating range of any single one of the two or more amplifiers.
10. A signal monitoring system comprising:
   a controller including one or more processors configured to:
   receive two or more digitized signals from two or more analog to digital converters configured to simultaneously digitize two or more amplified analog signals from two or more amplifiers with a common sampling rate, wherein the two or more amplifiers are configured to simultaneously amplify an input analog signal with different fixed gain values; and
   generate a full resolution signal from the two or more digitized signals by selecting on a sample-by-sample basis each value of the full resolution signal from a particular one of the two or more digitized signals associated with an undistorted representation of the input analog signal.
11. The signal monitoring system of clause 10, wherein selecting on the sample-by-sample basis each value of the full resolution signal from the particular one of the two or more digitized signals associated with the undistorted representation of the input analog signal comprises:
   identifying when any of the two or more digitized signals are distorted; and
   selecting on the sample-by-sample basis each value of the full resolution signal from the particular one of the two or more digitized signals associated with a highest gain while providing the undistorted representation of the input analog signal.
12. The signal monitoring system of clause 10 or clause 11, wherein the one or more processors of the controller are further configured to generate one or more measurements associated with the input analog signal based on the full resolution signal.
13. The signal monitoring system of any one of clauses 10 to 12, wherein the one or more processors of the controller are further configured to generate a constant-gain signal from at least one of the full resolution signal or the two or more digitized signals based on the fixed gain value associated with the particular one of the two or more digitized signals.
14. The signal monitoring system of clause 13, wherein the one or more processors of the controller are further configured to provide the constant-gain signal for display as a waveform representation of the input analog signal.
15. A signal monitoring method comprising:
   amplifying an input analog signal simultaneously with two or more amplifiers to generate two or more amplified analog signals, wherein each of the two or more amplifiers is configured to amplify the input analog signal with a different fixed gain value;
   digitizing the two or more amplified analog signals simultaneously with two or more analog to digital converters having a common sampling rate to generate two or more digitized signals; and
   generating a full resolution signal from the two or more digitized signals by selecting on a sample-by-sample basis each value of the full resolution signal from a particular one of the two or more digitized signals associated with an undistorted representation of the input analog signal.
16. The signal monitoring method of clause 15, wherein selecting on the sample-by-sample basis each value of the full resolution signal from the particular one of the two or more digitized signals associated with the undistorted representation of the input analog signal comprises:
   identifying when any of the two or more digitized signals are distorted; and
   selecting on the sample-by-sample basis each value of the full resolution signal from the particular one of the two or more digitized signals associated with a highest gain while providing the undistorted representation of the input analog signal.
17. The signal monitoring method of clause 15 or clause 16, further comprising:
   generating one or more measurements associated with the input analog signal based on the full resolution signal.
18. The signal monitoring method of clause 17, wherein the one or more measurements comprise:
   at least one of a root-mean-square (RMS) measurement, a current measurement, a voltage measurement, a power measurement, or an energy measurement.
19. The signal monitoring method of any one of clauses 15 to 18, further comprising:
   generating a constant-gain signal from at least one of the full resolution signal or the two or more digitized signals based on the fixed gain value associated with the particular one of the two or more digitized signals.
20. The signal monitoring method of clause 19, further comprising:
   providing the constant-gain signal for display as a waveform representation of the input analog signal.

It is believed that the present disclosure and many of its attendant advantages will be understood by the foregoing description, and it will be apparent that various changes may be made in the form, construction, and arrangement of the components without departing from the disclosed subject matter or without sacrificing all of its material advantages. The form described is merely explanatory, and it is the intention of the following claims to encompass and include such changes. Furthermore, it is to be understood that the present invention is defined by the appended claims.

## Claims

1. A signal monitoring system comprising:
a controller including one or more processors configured to:
receive two or more digitized signals from two or more analog to digital converters configured to simultaneously digitize two or more amplified analog signals from two or more amplifiers with a common sampling rate, wherein the two or more amplifiers are configured to simultaneously amplify an input analog signal with different fixed gain values; and
generate a full resolution signal from the two or more digitized signals by selecting on a sample-by-sample basis each value of the full resolution signal from a particular one of the two or more digitized signals associated with an undistorted representation of the input analog signal.

2. The signal monitoring system of claim 1, further comprising:
the two or more amplifiers to simultaneously amplify the input analog signal with different fixed gain values and generate the two or more amplified analog signals; and
the two or more analog to digital converters to simultaneously digitize the two or more amplified analog signals with the common sampling rate and generate the two or more digitized signals.

3. The signal monitoring system of claim 1 or claim 2, wherein selecting on the sample-by-sample basis each value of the full resolution signal from the particular one of the two or more digitized signals associated with the undistorted representation of the input analog signal comprises:
identifying when any of the two or more digitized signals are distorted; and
selecting on the sample-by-sample basis each value of the full resolution signal from the particular one of the two or more digitized signals associated with a highest gain while providing the undistorted representation of the input analog signal.

4. The signal monitoring system of any one of claims 1 to 3, wherein the one or more processors of the controller are further configured to generate one or more measurements associated with the input analog signal based on the full resolution signal.

5. The signal monitoring system of claim 4, wherein the one or more measurements comprise:
at least one of a root-mean-square (RMS) measurement, a current measurement, a voltage measurement, a power measurement, or an energy measurement.

6. The signal monitoring system of any one of claims 1 to 5, wherein the one or more processors of the controller are further configured to generate a constant-gain signal from at least one of the full resolution signal or the two or more digitized signals based on the fixed gain value associated with the particular one of the two or more digitized signals.

7. The signal monitoring system of claim 6, wherein the one or more processors of the controller are further configured to provide the constant-gain signal for display as a waveform representation of the input analog signal.

8. The signal monitoring system of any one of claims 1 to 7, wherein the one or more processors of the controller are configured to switch between different ones of the two or more digitized signals when generating the full resolution signal while maintaining signal continuity.

9. The signal monitoring system of any one of claims 1 to 8, wherein the two or more amplifiers comprise:
two amplifiers.

10. The signal monitoring system of any one of claims 1 to 9, wherein the input analog signal has a dynamic range exceeding an undistorted operating range of any single one of the two or more amplifiers.

11. A signal monitoring method comprising:
amplifying an input analog signal simultaneously with two or more amplifiers to generate two or more amplified analog signals, wherein each of the two or more amplifiers is configured to amplify the input analog signal with a different fixed gain value;
digitizing the two or more amplified analog signals simultaneously with two or more analog to digital converters having a common sampling rate to generate two or more digitized signals; and
generating a full resolution signal from the two or more digitized signals by selecting on a sample-by-sample basis each value of the full resolution signal from a particular one of the two or more digitized signals associated with an undistorted representation of the input analog signal.

12. The signal monitoring method of claim 11, wherein selecting on the sample-by-sample basis each value of the full resolution signal from the particular one of the two or more digitized signals associated with the undistorted representation of the input analog signal comprises:
identifying when any of the two or more digitized signals are distorted; and
selecting on the sample-by-sample basis each value of the full resolution signal from the particular one of the two or more digitized signals associated with a highest gain while providing the undistorted representation of the input analog signal.

13. The signal monitoring method of claim 11 or claim 12, further comprising:
generating one or more measurements associated with the input analog signal based on the full resolution signal,
wherein the one or more measurements optionally comprise:
at least one of a root-mean-square (RMS) measurement, a current measurement, a voltage measurement, a power measurement, or an energy measurement.

14. The signal monitoring method of any one of claims 11 to 13, further comprising:
generating a constant-gain signal from at least one of the full resolution signal or the two or more digitized signals based on the fixed gain value associated with the particular one of the two or more digitized signals.

15. The signal monitoring method of claim 14, further comprising:
providing the constant-gain signal for display as a waveform representation of the input analog signal.
